# EUROPEAN PATENT APPLICATION

(11) **EP 2 210 707 A2**
(43) Date of publication of application: **28.07.2010**
(21) Application number: 10151816.5
(22) Date of filing: 27.01.2010
(51) Int. Cl.: B24B 53/013, B24B 53/02, B24B 53/12, B24D 7/06

(54) **Lapping plate-conditioning grindstone segment, lapping plate-conditioning lapping machine, and method for conditioning lapping plate**

(30) Priority: 27.01.2009 JP 2009015517; 21.07.2009 JP 2009170336
(71) Applicant: Shinano Electric Refining Co., Ltd., Chiyoda-ku, Tokyo (JP)
(72) Inventor: Yasuoka, Kai, Chiyoda-ku Tokyo (JP); Shimizu, Tsuyoshi, Chiyoda-ku Tokyo (JP); Kazama, Kenichi, Chiyoda-ku Tokyo (JP)
(74) Representative: Nash, David Allan

(57) **Abstract**

In a lapping machine comprising a lapping plate and a conditioning carrier disposed thereon, the carrier being provided with bores for receiving conditioning grindstone segments, the lapping plate is polished and conditioned by cooperatively rotating the lapping plate and the carrier and feeding loose abrasive grains to the lapping plate. The conditioning grindstone segment of a shape of arcuated trapezoid having an included angle of 180°-90° is fitted in the carrier bore.

## Description

### TECHNICAL FIELD

This invention generally relates to a lapping machine comprising a lapping plate and a conditioning carrier disposed on the lapping plate, the carrier being provided with at least one bore for receiving a conditioning grindstone segment, wherein the lapping plate is conditioned by cooperatively rotating the lapping plate and the carrier and feeding loose abrasive grains to the lapping plate. More particularly, it relates to a grindstone segment for conditioning the lapping plate, and a lapping machine and method for conditioning the lapping plate.

### BACKGROUND ART

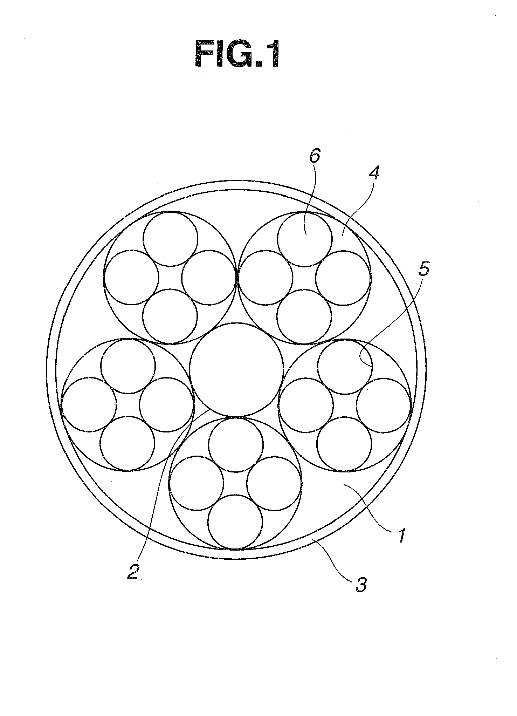

In the prior art, a lapping machine as shown in FIG. 1 is used for lapping workpieces such as silicon wafers, synthetic quartz glass, rock crystal, liquid crystal glass, and ceramics. The lapping machine of FIG. 1 includes a lower lapping plate 1 made of spheroidal graphite cast iron. The lapping plate 1 is rotatable about its axis by a drive (not shown). Inside the lapping plate 1, a sun gear 2 is disposed at the center and an annular internal gear 3 is disposed along the outer circumference. A plurality of carriers 4 are arranged in mesh with the gears 2 and 3. Each carrier 4 is provided with a plurality of workpiece-holding bores 5 which are loaded with workpieces 6 to be lapped. Though not shown, an upper lapping plate which is also rotatable like the upper lapping plate is disposed over the carriers 4. The lapping machine operates such that as the lapping plate 1 is revolved, the carriers 4 are counter rotated. At the same time, abrasive slurry is fed to the plate. Under cooperation of revolving plate with rotating carriers, the workpieces 6 are lapped with loose abrasive grains.

As lapping operations are repeated on the lapping machine, the lapping plates are worn into a convex or wavy shape. Then the flatness of workpieces lapped is worsened. Workpieces having satisfactory flatness are no longer obtained. Then the lapping plate is conditioned for flatness by using a lapping plate-conditioning jig made of cast iron like the lapping plates and feeding loose abrasive grains. In the prior art, several conditioning jigs for conditioning the surface accuracy of lapping plates of lapping machines are known from JP-A H11-10522, JP-A 2000-135666, JP-A 2000-218521, JP-A 2006-297488, and JP-A 2007-69323.

However, these lapping plate-conditioning jigs require a long time of conditioning operation until the lapping plate is resurfaced to the desired flatness. As a consequence, burrs form in holes resulting from combustion of spheroidal graphite present on the surface of the cast iron lapping plate at the end of polishing, and the cast iron lapping plate surface is roughened. In the recent trend, the lapping machine is substantially increased in size. For such a large size machine, the lapping plate-conditioning jig must be accordingly increased in size. The resultant increased weight makes the jig inconvenient to handle. There is a desire for a conditioning jig which is light weight and convenient to handle despite a large size of lapping machine, and a method capable of polishing and conditioning a lapping plate within a short time so that the lapping plate may develop a stable lapping force immediately after the start of lapping to produce a workpiece with minimal surface roughness.

### Citation List

Patent Document 1: JP-A H11-10522
Patent Document 2: JP-A 2000-135666
Patent Document 3: JP-A 2000-218521
Patent Document 4: JP-A 2006-297488
Patent Document 5: JP-A 2007-69323

### SUMMARY OF INVENTION

An object of the invention is to provide a lapping plate conditioning grindstone segment which is light weight despite a large size of lapping machine, and achieves within a short time conditioning of a lapping plate to form a uniform fine texture surface with spheroidal graphite holes opened on the lapping plate surface. Another object is to provide a lapping machine and method for the conditioning of a lapping plate.

Conducting a simulative research of monitoring the progress of lapping of a workpiece on a lapping machine with time, the inventors have found an ideal lapping plate-conditioning jig shape capable of polishing the lapping plate uniformly. Use of a jig made of a grindstone having micropores of equivalent size to spheroidal graphite holes present in the cast iron lapping plate and preferably a Rockwell hardness (HRS) of 80 to 150, specifically synthetic resin bond grindstone or cast iron grindstone makes it possible to achieve within a short time conditioning of a lapping plate to form a uniform fine texture surface with spheroidal graphite holes opened on the lapping plate surface, as compared with the surface conditioning of a lapping plate using a prior art lapping plate-conditioning jig such as a conditioning carrier made of ceramics, metal or the like. When a workpiece is actually lapped using loose abrasive grains, adequate abrasive grains are caught within opened spheroidal graphite holes on the lapping plate surface, the retaining force of grains within holes is increased to produce a stable lapping force, and the fine texture surface of the lapping plate is transferred to the workpiece. Thus the workpiece is finished to a minimal surface roughness.

The invention pertains to a lapping machine comprising a lapping plate and a conditioning carrier disposed on the lapping plate, the carrier being provided with at least one bore for receiving a conditioning grindstone segment, wherein the lapping plate is polished and conditioned by cooperatively rotating the lapping plate and the carrier and feeding loose abrasive grains to the lapping plate. In a first aspect, the invention provides the conditioning grindstone segment which is fitted in the bore in the carrier has a shape of arcuated trapezoid defining an included angle of 180° to 90° with respect to the center of the corresponding circle.

Preferably the shape of the conditioning grindstone segment has a radial width of 10 to 20% of the diameter of the circle.

Preferably the conditioning grindstone segment has a Rockwell hardness (HRS) of 80 to 150. The conditioning grindstone segment is preferably microporous.

In one embodiment, the conditioning grindstone segment is a synthetic resin bond grindstone segment, preferably having a microporosity of 50 to 90% by volume. More preferably it is a microporous polyurethane bond grindstone segment having a pore size of 20 to 150 µm. Further preferably, abrasive grains are distributed and bonded in the grindstone, desirably in an amount of 20 to 50% by weight of the grindstone, the abrasive grains being the same as loose abrasive grains used in lapping of workpieces.

In another embodiment, the conditioning grindstone segment is a cast iron grindstone segment, preferably having a microporosity of 10 to 50% by volume.

In a second aspect, the invention provides a lapping plate-conditioning lapping machine comprising a lapping plate and a conditioning carrier disposed on the lapping plate, the carrier being provided with at least one bore for receiving a conditioning grindstone segment, wherein the lapping plate is polished and conditioned by cooperatively rotating the lapping plate and the carrier and feeding loose abrasive grains to the lapping plate, the conditioning grindstone segment of the first aspect being fitted in the bore in the carrier.

In a preferred embodiment, the carrier is provided with 2 to 20 circumferentially spaced apart bores each for receiving a conditioning grindstone segment so that the conditioning grindstone segments fitted in the bores figure a petal shape as a whole.

In a third aspect, the invention provides a method for conditioning the lapping plate using the conditioning lapping machine of the second aspect. Preferably loose abrasive grains are fed to the lapping plate during the conditioning operation.

### ADVANTAGEOUS EFFECTS OF INVENTION

As compared with the surface conditioning of a lapping plate using a prior art conditioning jig such as a conditioning carrier made of ceramics, metal or the like and abrasive grains, the invention makes it possible to achieve within a short time conditioning of a lapping plate and simultaneously opening of spheroidal graphite holes on the lapping plate surface and formation of a uniform fine texture surface. When a workpiece is actually lapped with the lapping plate using loose abrasive grains, adequate abrasive grains are caught within opened spheroidal graphite holes on the lapping plate surface at an increased retaining force so that a stable lapping force is produced, and the fine texture surface of the lapping plate is transferred to the workpiece. Thus the workpiece is finished to a minimal surface roughness.

### BRIEF DESCRIPTION OF DRAWINGS

FIG. 1 is a schematic plan view of one exemplary lapping machine for lapping workpieces, with the upper lapping plate omitted.
FIG. 2 is a plan view of a lapping plate-conditioning lapping machine in one embodiment of the invention, with the upper lapping plate omitted.
FIG. 3 illustrates in plan view exemplary arc grindstone segments, FIG. 3A showing a segment having an included angle of 180°, and FIG. 3B showing a segment having an included angle of 90°.
FIG. 4 illustrates the arrangement of disk-shaped grindstones within a carrier.
FIG. 5A illustrates the arrangement of disk-shaped workpieces within a lapping plate. FIG. 5B is a plan view showing a lapping simulation.
FIG. 6 illustrates the arrangement of ring-shaped grindstones within a carrier.
FIG. 7A illustrates the arrangement of ring-shaped workpieces within a lapping plate. FIG. 7B is a plan view showing a lapping simulation.
FIG. 8 illustrates the petal-configured assembly of arc-shape grindstones within a carrier.
FIG. 9A illustrates the arrangement of petal-configured assemblies of arc-shaped workpieces within a lapping plate. FIG. 9B is a plan view showing a lapping simulation.
FIG. 10 is a plan view of a prior art conditioning cast iron carrier.
FIG. 11 is a photomicrograph (×100) of the surface of a lapping plate which has been conditioned by the prior art conditioning cast iron carrier.
FIG. 12 is a photomicrograph (×100) of the surface of a lapping plate which has been conditioned by the petal-configured assembly of arc-shaped synthetic resin bond grindstone segments according to the invention.
FIG. 13 is a photomicrograph (×100) of the surface of an arc-shaped synthetic resin bond grindstone segment in the petal-configured assembly according to the invention.
FIG. 14 shows the distribution of points for lapping plate profile measurement.
FIG. 15 is a diagram showing the height of a conditioned lapping plate relative to measurement points in Example and Comparative Example.
FIG. 16 is a diagram showing batch No. and the material removal when silicon wafers were lapped in Example and Comparative Example.
FIG. 17 is a diagram showing batch No. and 10-point average surface roughness when silicon wafers were lapped in Example and Comparative Example.

### DESCRIPTION OF EMBODIMENTS

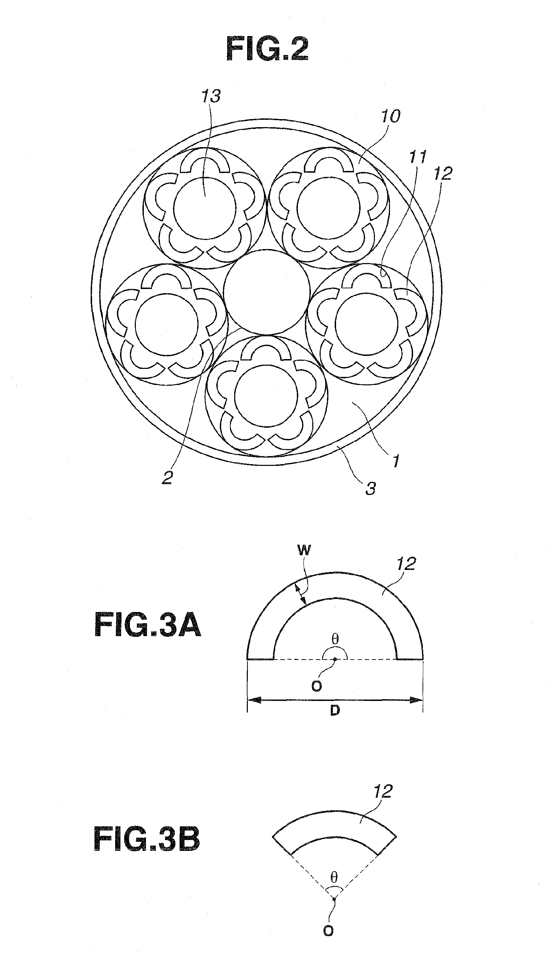

FIG. 2 illustrates a lapping plate-conditioning lapping machine in one embodiment of the invention. This lapping machine is similar to that shown in FIG. 1 except that instead of the carriers 4, lapping plate-conditioning carriers 10 having conditioning grindstone segment-receiving bores 11 are arranged in mesh with gears 2 and 3. Polishing and conditioning is carried out by fitting conditioning grindstone segments 12 in the bores 11 in the carriers 10, cooperatively rotating the lapping plate 1 and the carriers 10, and feeding loose abrasive grains to the lapping plate 1. The conditioning grindstone segment 12 fitted in the bore 11 in the carrier 10 has an arc shape in plan view and a plate or rectangular shape in cross section and is typically a synthetic resin bond or cast iron grindstone. The bore 11 has a corresponding arc shape conforming to the shape of grindstone segment 12 so that the grindstone segment 12 may fit in the bore 11. An abrasive grain slurry is passed from the upper lapping plate to the lower lapping plate through communication ports 13.

As used herein, the term "arc" shape is an annular segment having a radial width, like a piece of paper extended over and attached to radial ribs of a fan, more specifically a segment delimited by two concentric circles and two radial lines defining an included angle θ of up to 180° with respect to the center O of the corresponding circle (see FIG. 3).

Conducting a simulative research of monitoring the progress of lapping of a workpiece on a lapping machine with time, the inventors have found that an arc shape having an included angle θ of 180° to 90° with respect to the center O of the corresponding circle is an ideal shape for the lapping plate conditioning jig capable of polishing the lapping plate uniformly. If the included angle of an arc shape is less than 90°, the surface area of the grindstone segment in contact with the lapping plate is substantially reduced and consequently, the amount of grindstone consumed is increased, which is uneconomical. If the included angle of an arc shape is more than 180°, chances of contact with those grindstone segments disposed inward of the intermediate of the lapping plate width increase, failing in uniform conditioning of the lapping plate.

FIGS. 3A and 3B show typical arc shape grindstone segments. FIG. 3A shows an arc shape having an included angle θ of 180°, that is, a semi-annular shape. FIG. 3B shows an arc shape having an included angle θ of 90°, that is, a quadrant-annular shape. The included angle θ is in the range of 180° to 90°, with the range of 160° to 120° being preferred.

The arc shape grindstone segment has a radial width W which is in a range of 10 to 20% of the diameter D of the circle. If the segment width W is less than 10% of the diameter D, chances of grindstone segments contacting with the lapping plate become more uniform (which is preferable), but the surface area of the grindstone segment in contact with the lapping plate is substantially reduced and consequently, the amount of grindstone consumed may be increased, which is uneconomical. If the segment width W is more than 20% of the diameter D, the contact surface area is increased to avoid the economic problem, but chances of contact with those grindstone segments disposed inward of the intermediate of the lapping plate width may increase, failing in uniform conditioning of the lapping plate.

The grindstone used herein is preferably a synthetic resin bond grindstone or cast iron grindstone. The synthetic resin bond grindstone is preferably microporous. Polyurethane is preferred among synthetic resins because it has water repellency, heat resistance, and mechanical strength, and forms a grindstone containing closed micropores in the interior. Polyurethane-bonded grindstones may be prepared by combining a polyol, for example, a polyester polyol (e.g., polyethylene adipate, polyhexamethylene adipate, polycaprolactone polyol, polycarbonate diol) or a polyether polyol (e.g., polypropylene glycol, polyethylene glycol, polytetramethylene glycol) with an isocyanate such as tolylene 2,4-diisocyanate (TDI) or 4,4'-diphenylmethane diisocyanate (MDI), adding thereto abrasive grains, preferably the same abrasive grains as used in the lapping operation, and high-speed mixing the ingredients in a static mixer for allowing urethane bond reaction to occur under the action of a catalyst (e.g., tertiary amine, triethylenediamine, metal salt, or water) previously added in a minute amount to the polyol. It is noted that a microporous polyurethane-bonded grindstone is preferably prepared by mixing a polyol and an isocyanate in a static mixer at a high speed of 2,000 to 5,000 rpm so that urethane reaction may take place.

Preferably the microporous synthetic resin bond grindstone is water repellent and has a closed cell structure rather than an open cell structure.

Preferably the microporous synthetic resin bond grindstone has fine abrasive grains distributed therein. Abrasive grains are preferably present in an amount of 20 to 50% by weight, more preferably 30 to 40% by weight of the overall grindstone. Abrasive grains are preferably as fine as an average grain size of about 20 µm to 1 µm. They may be made of silicon carbide, alumina, chromium oxide, cerium oxide, zirconium oxide or zircon sand, or a mixture of two or more of the foregoing. For use in the polishing and conditioning of lapping plates, the abrasive grains are preferably of the same material and grain size as the loose abrasive grains used in lapping of workpieces.

When abrasive grains are incorporated in this way, the resultant grindstone having abrasive grains distributed and bound therein is more effective in polishing and conditioning of a lapping plate. When abrasive grains of the same material and grain size as the loose abrasive grains used in lapping of workpieces are distributed and bound in the grindstone, the following advantage is obtained. Upon polishing and conditioning of a lapping plate with these grindstone segments, abrasive grains may be released from the grindstone and deposited on the surface of the lapping plate at the end of polishing and conditioning. Even so, the problem that residual abrasive grains would otherwise cause scratches or defects to workpieces is avoided because they are the same as loose abrasive grains used in lapping of workpieces.

The cast iron grindstone is preferably microporous, and more preferably one having closed micropores in its interior. Such a grindstone is prepared by adding spheroidal graphite to an iron melt, and casting the melt so that spheroidal graphite burns to form micropores in the cast iron. Typical of such cast iron is cast iron FCD 450.

The grindstone preferably has a Rockwell hardness (HRS) of 80 to 150, more preferably 100 to 130, and even more preferably 110 to 120. If the Rockwell hardness is too low, the amount of grindstone consumed by polishing may be increased beyond the economically acceptable level. A grindstone having too high a Rockwell hardness, which is higher than the hardness of cast iron lapping plates, may lose the self-release mechanism, failing in uniform conditioning of lapping plates. It is noted that the Rockwell hardness is a HRS value as measured using a steel ball indenter with a diameter of 1/2 inch as the scale and under a test load of 100 kg.

As described above, the microporous grindstone preferably contains micropores or micro-cells, which preferably have a cell size (or diameter) of at least 20 µm, more preferably at least 40 µm, and even more preferably at least 50 µm, and up to 200 µm, more preferably up to 150 µm, and even more preferably up to 80 µm. In the case of synthetic resin bond grindstone, a cell size of 20 to 150 µm, especially 40 to 80 µm is preferred. In the case of cast iron grindstone, a cell size of 50 to 200 µm is preferred. A smaller cell size below the range may restrict motion of the abrasive grain slurry dispersed during polishing, leading to uneven polishing. A larger cell size beyond the range facilitates motion of the abrasive grain slurry for uniform polishing, but may provide a rough grindstone structure, resulting in an increased grindstone consumption beyond the economically acceptable level.

The microporous synthetic resin bond grindstone preferably has a microporosity of 50 to 90% by volume, more preferably 60 to 80% by volume. A porosity of less than 50% corresponds to a reduced number of micropores present in the surface in abutment with the lapping plate and hence, retention of less grains in the abrasive grain slurry dispersed during polishing, leading to a reduced lapping plate conditioning capability. A porosity of more than 90% corresponds to an increased force of retaining grains during polishing and hence, an increased lapping plate conditioning capability, but may lead to a rough grindstone structure, resulting in an increased grindstone consumption beyond the economically acceptable level.

The microporous cast iron grindstone has advantages over the microporous synthetic resin grindstone, including a consumption amount which is less than 1/3 of that of the synthetic resin grindstone, less self-release, and less shape collapse. It preferably has a microporosity of 10 to 50% by volume, more preferably 20 to 40% by volume. At a porosity of less than 10%, little self-release of cast iron occurs during polishing; once micropores are clogged during polishing, dressing is no longer possible and few grains in the abrasive grain slurry dispersed during polishing are retained, leading to an extremely reduced lapping plate conditioning capability. If the cast iron grindstone has a porosity of more than 50%, an amount of grindstone consumed becomes equal to that of the synthetic resin grindstone, and cast iron particles self released from the cast iron grindstone during polishing may give rise to a phenomenon of causing flaws to the lapping plate during lapping, as opposed to self-release particles from the synthetic resin grindstone during polishing.

The time when the lapping plate is conditioned using the conditioning grindstone segments of the invention is not particularly limited. As lapping of workpieces is repeatedly carried out, the upper and lower lapping plates are also abraded by abrasive grains used in lapping, whereby the surface accuracy is aggravated into a convex or wavy shape. The operation of conditioning the convex or wavy surface of the lapping plate into a surface having a high accuracy is carried out using the conditioning grindstone segments of the invention. The lapping plate having a flat surface of high accuracy is obtained within a shorter time, as compared with conventional conditioning cast iron carriers. In addition, spheroidal graphite holes are opened on the surface of the lapping plate and a uniform fine texture surface is obtained. Then, when a workpiece is actually lapped with the conditioned lapping plate using loose abrasive grains, adequate grains are retained within spheroidal graphite holes present on the plate surface, and the retaining force is increased to provide a stable lapping force. The fine texture plate surface is transferred to the workpiece, the workpiece being finished to a minimal surface roughness. The lapping plate used in lapping or to be conditioned herein is not particularly limited. A lapping plate of spheroidal graphite cast iron is preferred in the practice of the invention.

Using the grindstone segments of the invention, the lapping plate is conditioned as follows. As shown in FIG. 2, each of carriers 10 of glass fiber-reinforced epoxy resin has grindstone segment-receiving bores 11. Arc grindstone segments 12 are fitted in the bores 11. Besides the bores 11, the carrier 10 also has a communication port 13 for uniform flow of the abrasive grain slurry from the upper lapping plate to the lower lapping plate during lapping operation. The carriers 10 having arc grindstone segments 12 held therein are set in mesh with sun gear 2 and internal gear 3 and between the upper and lower lapping plates. The abrasive grain slurry is fed so as to flow from the upper to the lower lapping plate. The lapping plates are rotated in one direction. While the weight of the upper plate is borne by the arc grindstone segments 12, the carriers 10 are rotated in an opposite direction. Polishing operation is carried out in this way for conditioning the upper and lower lapping plates. The number of carriers 10 arranged is preferably 2 to 16, more preferably 4 to 10.

The polishing conditions employed in the conditioning operation may be selected from wide ranges, and are preferably the same conditions as those used in lapping of workpieces following the conditioning.

During the polishing operation on lapping plates using the grindstone segments of the invention, it is preferred to feed loose abrasive grains which are the same as loose abrasive grains used in subsequent lapping of workpieces. The reason is that even if some loose abrasive grains are left on the lapping plates following the polishing and conditioning thereof by the grindstone segments, they do not interfere with subsequent lapping of workpieces.

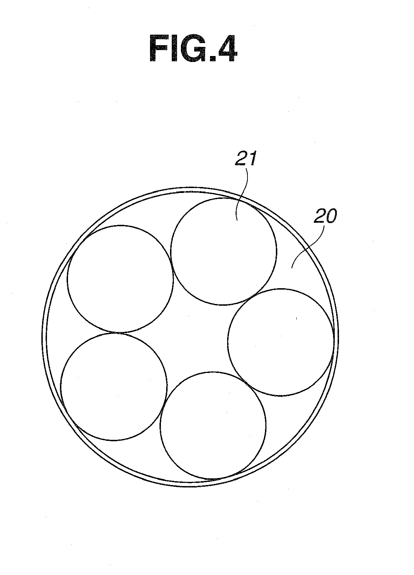

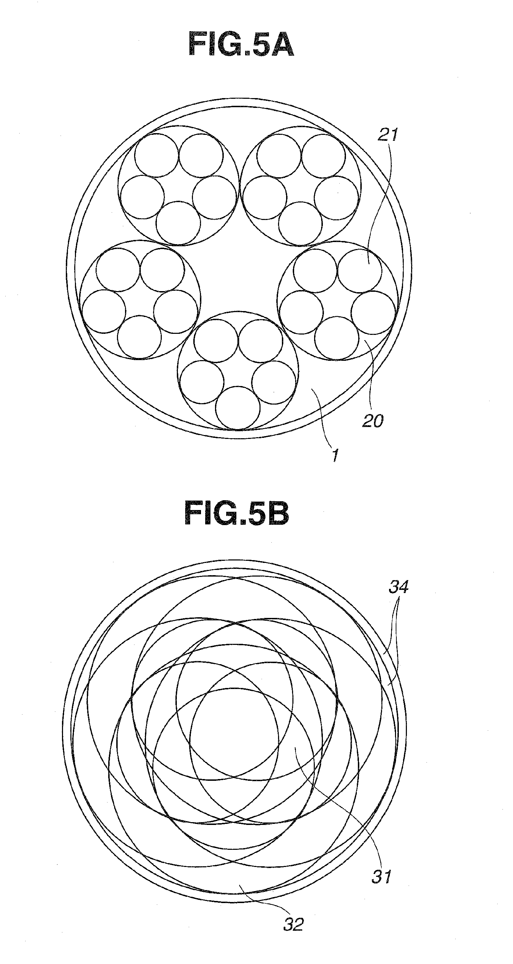

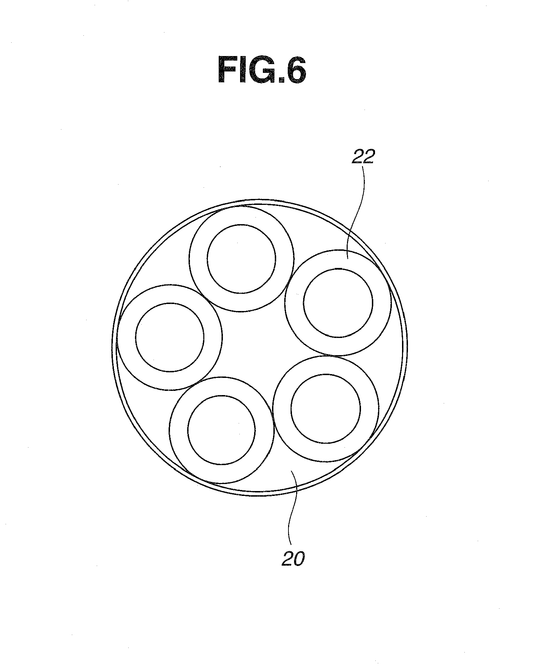

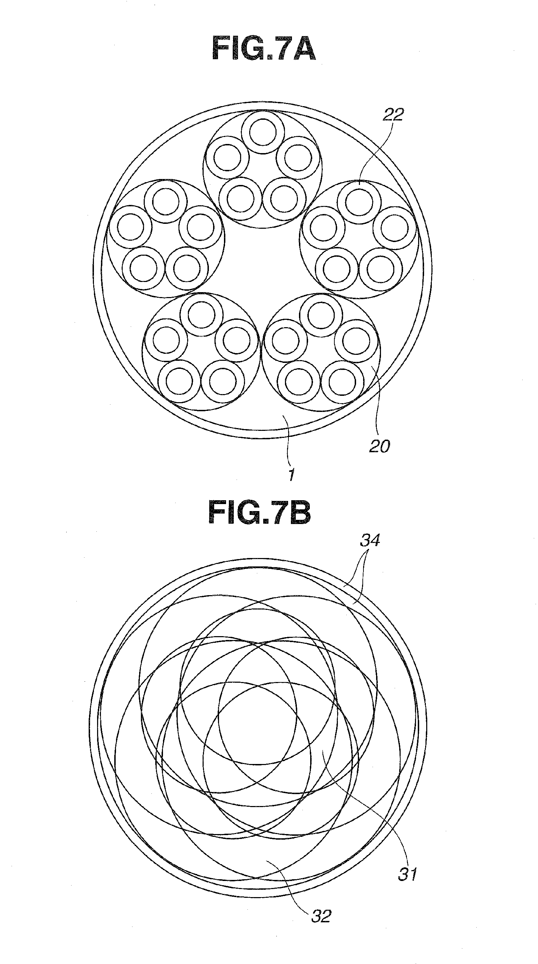

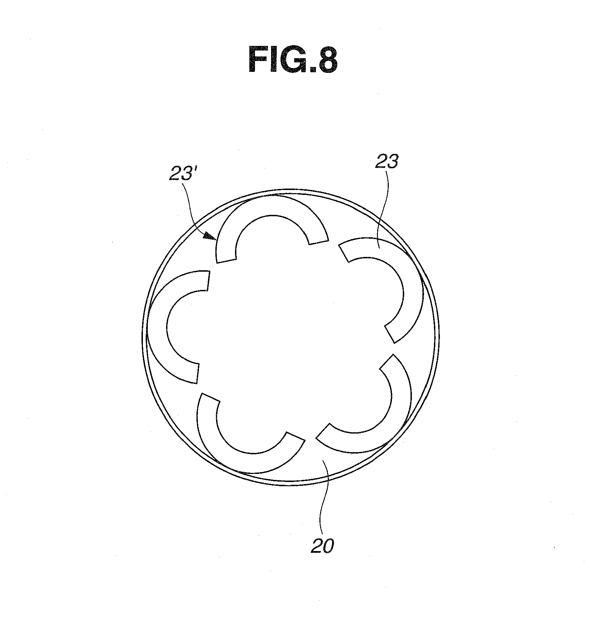

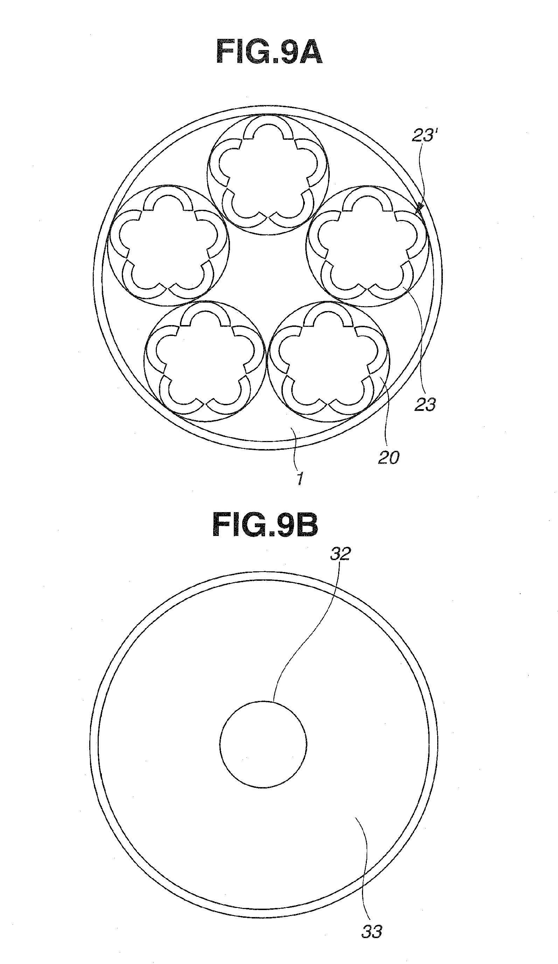

A simulative experiment was carried out to monitor the course of lapping of a workpiece on a lapping machine over time. FIG. 5A shows an arrangement on a lapping plate 1 of carriers 20 that carry disk-shaped workpieces 21 as shown in FIG. 4, FIG. 7A shows an arrangement on a lapping plate of carriers 20 that carry ring-shaped workpieces 22 as shown in FIG. 6, and FIG. 9A shows an arrangement on a lapping plate of carriers 20 that carry arc-shaped workpieces 23 (which figure a petal shape 23' as a whole) as shown in FIG. 8. FIGS. 5B, 7B, and 9B show the states of the respective lapping plate surfaces following lapping. Revolution and rotation of a workpiece on the lapping machine cooperates to repeat the contact of the workpiece with the lapping plate surface. The lapping plate surface includes an area 31 having an increased frequency of contacts and an area 32 having a moderate frequency of contacts, or an area 33 having a uniform frequency of contacts. The simulation reveals that the area having an increased frequency of contacts of the workpiece with the lapping plate surface resulting from revolution and rotation of the workpiece on the lapping machine decreases in the order from disk-shaped workpieces to ring-shaped workpieces, and the assembly of arc-shaped workpieces (which figure a petal shape as a whole) results in a uniform frequency of contacts. The lapping plate 1 includes an area 34 which is out of contact with workpieces.

The simulation results indicate that arc-shaped segments are used as the grindstone, and preferably a plurality of, specifically 2 to 20, and more specifically 4 to 12 arc-shaped grindstone segments are held on a carrier and spaced apart in a circumferential direction (rotational direction) of the carrier, with a radial direction of the arc shape aligned with a radial direction of the carrier. More preferably, arc-shaped grindstone segments are held on the carrier, with the outer circle edge of the arc-shaped grindstone segment being in tangential register with the outer circumferential edge of the carrier, so as to figure a petal or corolla assembly as a whole. Further preferably, a plurality of, specifically 2 to 16, and more specifically 4 to 10 carriers, each having arc-shaped grindstone segments arranged in a petal assembly, are arranged on the lapping plate in a revolving direction of the carriers (circumferential direction of the lapping plate).

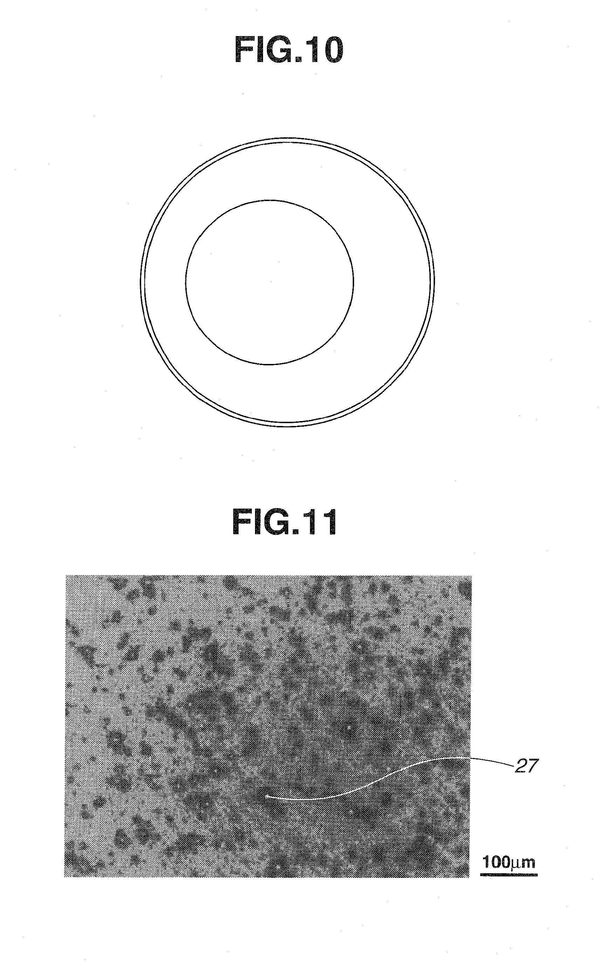

FIG. 11 shows the surface state of a lapping plate which has been polished and conditioned by a conventional conditioning cast iron carrier as shown in FIG. 10. It is seen that burrs form at holes 27 resulting from combustion of spheroidal graphite present on the surface of the cast iron lapping plate after polishing. The surface of the cast iron lapping plate is roughened.

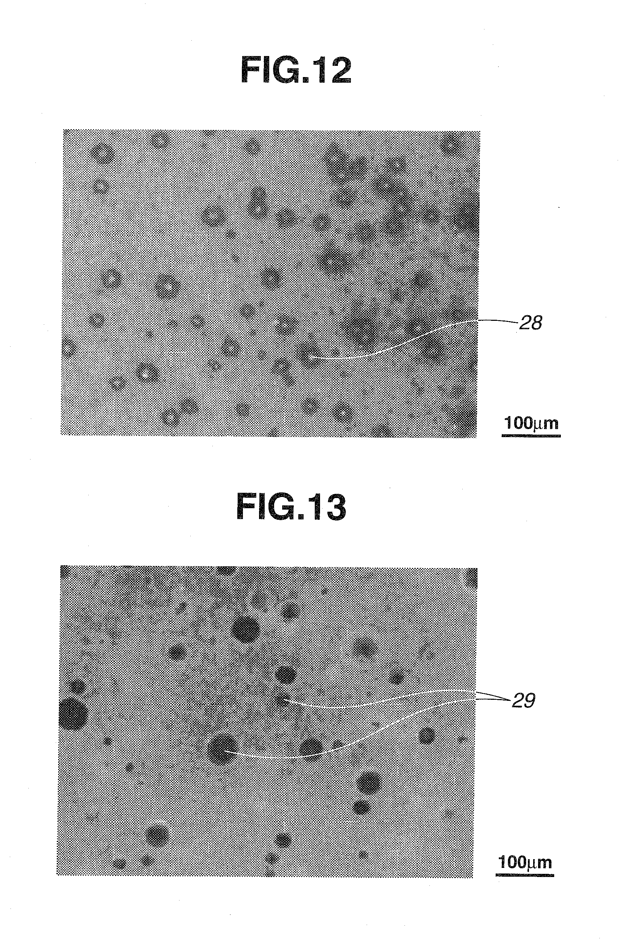

This is in contrast to the surface state of a lapping plate which has been polished and conditioned by a petal-configured assembly of arc shape segments of synthetic resin grindstone or cast iron grindstone. FIG. 12 shows the surface state of a lapping plate which has been polished and conditioned by a petal-configured assembly of arc shape segments of synthetic resin bond grindstone. The photomicrograph indicates opening of spheroidal graphite holes present on the lapping plate surface and formation of a uniform fine texture surface. Good holes 28 result from combustion of spheroidal graphite present on the surface of the cast iron lapping plate. When a workpiece is actually lapped with the conditioned lapping plate using loose abrasive grains, adequate abrasive grains are caught within spheroidal graphite holes on the lapping plate surface at so high a retaining force that a stable lapping force is produced, and the fine texture surface of the lapping plate is transferred to the workpiece. Thus the workpiece is finished to a minimal surface roughness.

FIG. 13 shows the surface state of the grindstone segment after a lapping plate has been polished and conditioned by a petal-configured assembly of arc shape segments of synthetic resin grindstone. While the abrasive grain slurry is dispersed during polishing operation, adequate abrasive grains are retained within micropores 29 whereby polishing and conditioning of the lapping plate is completed within a short time.

### EXAMPLE

Example and Comparative Example are given below by way of illustration and not by way of limitation.

### Examples and Comparative Examples

The lapping machine used herein is a 4-way-motion double side lapping machine 16B (Fujikoshi Machinery Corp.). The carriers tested are a carrier having bores for receiving synthetic resin bond grindstone disks as shown in FIG. 4, a carrier having bores for receiving synthetic resin bond grindstone rings as shown in FIG. 6, a carrier having bores for receiving arc shape synthetic resin bond grindstone segments as shown in FIG. 8, and a conventional conditioning cast iron carrier as shown in FIG. 10. Using these carriers, upper and lower lapping plates were polished and conditioned by the following method and conditions.

### Lapping plate polishing/conditioning conditions

Lapping plate
Material: spheroidal graphite cast iron FCD 450
Size: 16B, diameter 1127 mm

Carrier
Number: 5
Size: diameter 423 mm

Conditioning method and conditions
Polishing load: 100 g/cm² (∼9.8 kPa)
Lower lapping plate revolution: 60 rpm
Upper lapping plate revolution: 20 rpm
Loose abrasive grains: FO #1200
Abrasive concentration: 20 wt% dispersion
Abrasive slurry feed rate: 200 ml/min
Polishing time: 30 min

The type of grindstone used in the conditioning is identified in Table 1.

**Table 1: Grindstone**

| | Example | Comparative Example | |
|---|---|---|---|
| Designation | GS-1 | GS-2 | GS-3 |
| Shape | arc | ring | disk |
| Figure | FIG. 8 | FIG. 6 | FIG. 4 |
| Resin | polyurethane | polyurethane | polyurethane |
| Pore size (µm) | 50 | 50 | 100 |
| Porosity (%) | 70 | 80 | 90 |
| Abrasive grains | FO#1200 | FO#1200 | FO#1200 |
| Abrasive fraction (wt%) | 35 | 40 | 45 |
| Rockwell hardness (HRS) | 110 | 100 | 90 |

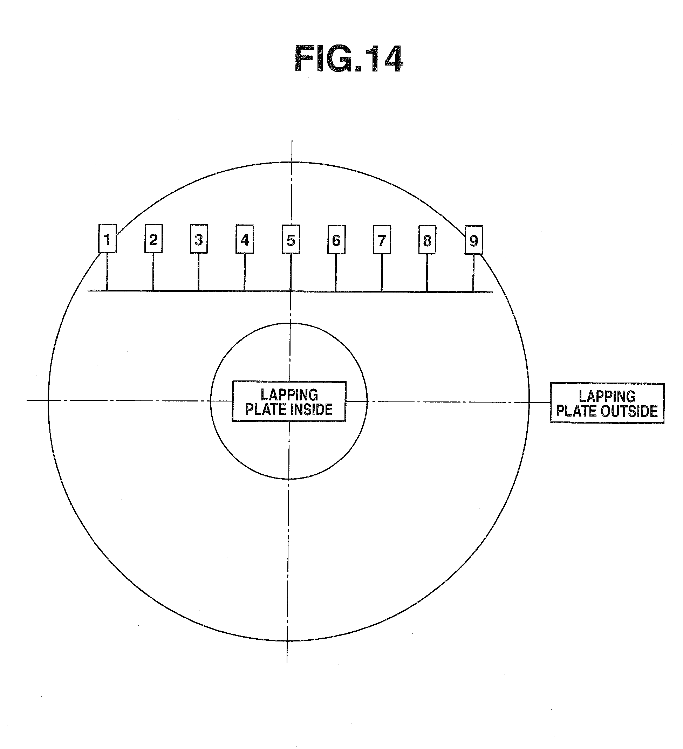

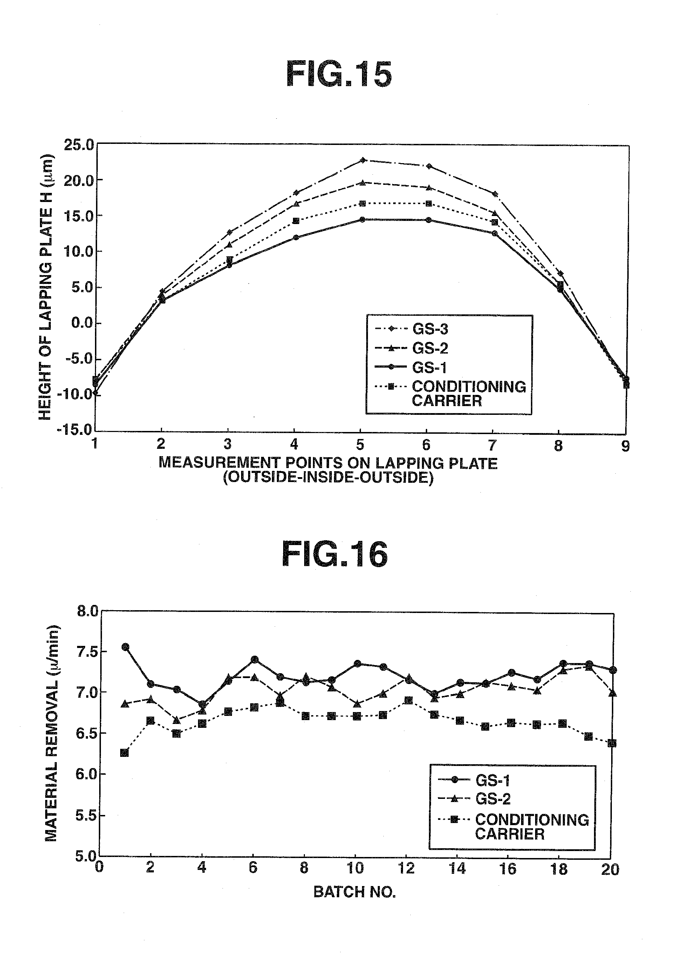

The surface profile of the lapping plate which had been polished and conditioned under the above conditions was measured by a lapping plate flatness gauge as shown in FIG. 14. The measurement data are shown in Table 2 and plotted in the diagram of FIG. 15.

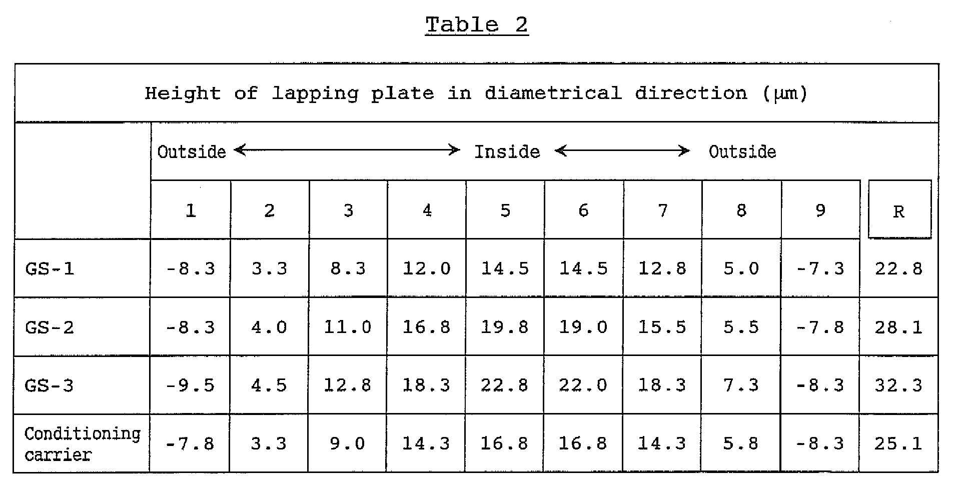

The R value is given by the difference between maximum and minimum heights of the lapping plate in its diametrical direction and indicates a lapping plate conditioning capability. It is seen from the results of conditioning that the petal-configured assembly of arc grindstone segments (GS-1) gives the lowest R value, demonstrating that the lapping plate is polished to a uniform surface.

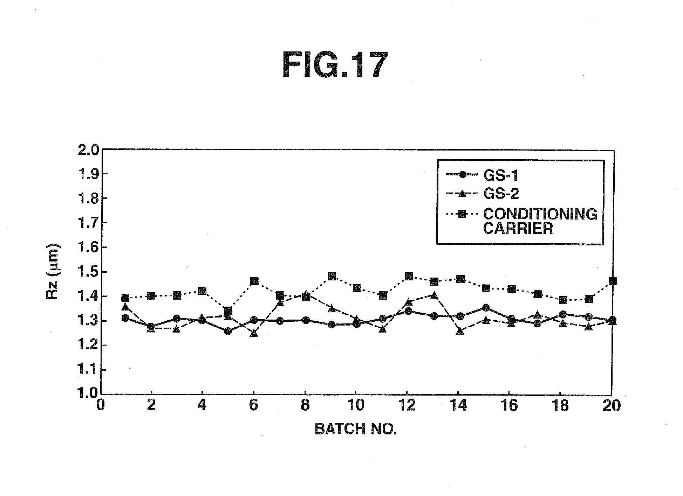

Another test was carried out using the 4-way-motion double side lapping machine 16B. The carriers tested are a carrier having bores for receiving synthetic resin bond grindstone rings as shown in FIG. 6, a carrier having bores for receiving arc shape synthetic resin grindstone segments as shown in FIG. 8, and a conventional conditioning cast iron carrier as shown in FIG. 10. Using these carriers, upper and lower lapping plates were polished and conditioned by the above-mentioned method and conditions. Using the lapping plates thus conditioned, silicon wafers were repeatedly lapped under the following conditions. The results are shown in Tables 3 and 4 and FIGS. 16 and 17.

### Silicon wafer lapping conditions

Work: silicon wafer
Work size: diameter 6 inch (150 mm)
Number of works per batch: 20
Lapping time per batch: 10 min
Recycle: no
Upper lapping plate revolution: 20 rpm
Lower lapping plate revolution: 60 rpm
Load: 100 g/cm² (∼9.8 kPa)
Slurry concentration: 20 wt%
Rust preventive: 1 wt%
Dispensing rate: 200 ml/min
Abrasive grains: FO #1200
Number of carriers: 5

**Table 3: Material removal (µm/min)**

| Batch No. | GS-1 | GS-2 | Conditioning carrier |
|---|---|---|---|
| 1 | 7.56 | 6.88 | 6.27 |
| 2 | 7.10 | 6.93 | 6.66 |
| 3 | 7.05 | 6.66 | 6.51 |
| 4 | 6.88 | 6.79 | 6.63 |
| 5 | 7.15 | 7.19 | 6.77 |
| 6 | 7.41 | 7.21 | 6.83 |
| 7 | 7.20 | 6.97 | 6.87 |
| 8 | 7.14 | 7.21 | 6.72 |
| 9 | 7.17 | 7.08 | 6.73 |
| 10 | 7.37 | 6.88 | 6.73 |
| 11 | 7.33 | 7.00 | 6.74 |
| 12 | 7.18 | 7.20 | 6.92 |
| 13 | 7.00 | 6.96 | 6.75 |
| 14 | 7.15 | 7.01 | 6.68 |
| 15 | 7.13 | 7.15 | 6.61 |
| 16 | 7.27 | 7.12 | 6.65 |
| 17 | 7.19 | 7.06 | 6.64 |
| 18 | 7.39 | 7.31 | 6.66 |
| 19 | 7.38 | 7.36 | 6.50 |
| 20 | 7.31 | 7.05 | 6.42 |
| Average | 7.22 | 7.05 | 6.66 |
| σ | 0.16 | 0.17 | 0.15 |
| MANX | 7.56 | 7.36 | 6.92 |
| MIN | 6.88 | 6.66 | 6.27 |
| R | 0.68 | 0.70 | 0.65 |

**Table 4: 10-point average surface roughness Rz (µm)**

| Batch No. | GS-1 | GS-2 | Conditioning carrier |
|---|---|---|---|
| 1 | 1.313 | 1.356 | 1.389 |
| 2 | 1.275 | 1.268 | 1.404 |
| 3 | 1.305 | 1.269 | 1.401 |
| 4 | 1.300 | 1.314 | 1.419 |
| 5 | 1.255 | 1.320 | 1.342 |
| 6 | 1.302 | 1.251 | 1.462 |
| 7 | 1.297 | 1.375 | 1.403 |
| 8 | 1.301 | 1.408 | 1.397 |
| 9 | 1.285 | 1.346 | 1.478 |
| 10 | 1.280 | 1.305 | 1.432 |
| 11 | 1.308 | 1.269 | 1.399 |
| 12 | 1.339 | 1.377 | 1.484 |
| 13 | 1.320 | 1.407 | 1.461 |
| 14 | 1.320 | 1.259 | 1.472 |
| 15 | 1.353 | 1.306 | 1.434 |
| 16 | 1.310 | 1.289 | 1.430 |
| 17 | 1.287 | 1.325 | 1.409 |
| 18 | 1.325 | 1.295 | 1.386 |
| 19 | 1.319 | 1.280 | 1.388 |
| 20 | 1.307 | 1.305 | 1.466 |
| Average | 1.305 | 1.316 | 1.423 |
| σ | 0.022 | 0.047 | 0.037 |
| MANX | 1.353 | 1.408 | 1.484 |
| MIN | 1.255 | 1.251 | 1.342 |
| R | 0.098 | 0.157 | 0.142 |

It is seen from the results of silicon wafer lapping that the petal-configured assembly of arc grindstone segments (GS-1) leads to the highest material removal (µm) and the lowest 10-point average surface roughness Rz (µm).

It is demonstrated that spheroidal graphite holes present on the lapping plate surface are opened and a uniform fine texture surface is formed. When a workpiece is actually lapped with the conditioned lapping plate using loose abrasive grains, adequate abrasive grains are caught within spheroidal graphite holes on the lapping plate surface at so high a retaining force that a stable lapping force is produced, and the fine texture surface of the lapping plate is transferred to the workpiece. Thus the workpiece is finished to a minimized surface roughness.

## Claims

1. A conditioning grindstone segment having a shape of an arcuated trapezoid defining an included angle of 180° to 90° with respect to the center of the corresponding circle for use in a lapping machine comprising a lapping plate and a conditioning carrier disposed on the lapping plate, the carrier being provided with at least one bore for receiving the conditioning grindstone segment, wherein the lapping plate is polished and conditioned by cooperatively rotating the lapping plate and the carrier and feeding loose abrasive grains to the lapping plate.

2. The conditioning grindstone segment of claim 1 wherein the shape of the conditioning grindstone segment has a radial width of 10 to 20% of the diameter of the circle.

3. The conditioning grindstone segment of claim 1 or 2, which has a Rockwell hardness (HRS) of 80 to 150.

4. The conditioning grindstone segment of claim 1, 2 or 3, which is microporous.

5. The conditioning grindstone segment of anyone of claims 1 to 4, which is a synthetic resin bond grindstone segment.

6. The conditioning grindstone segment of claim 5, which has a microporosity of 50 to 90%.

7. The conditioning grindstone segment of claim 5 or 6, which is a microporous polyurethane bond grindstone segment having a pore size of 20 to 150 µm.

8. The conditioning grindstone segment of claim 5, 6 or 7, which has abrasive grains distributed and bonded therein, said abrasive grains being the same as loose abrasive grains used in lapping of workpieces.

9. The conditioning grindstone segment of claim 8 wherein the abrasive grains are present in an amount of 20 to 50% by weight of the grindstone.

10. The conditioning grindstone segment of anyone of claims 1 to 4, which is a cast iron grindstone segment.

11. The conditioning grindstone segment of claim 10, which has a microporosity of 10 to 50%.

12. A lapping plate-conditioning lapping machine comprising a lapping plate and a conditioning carrier disposed on the lapping plate, the carrier being provided with at least one bore for receiving a conditioning grindstone segment, wherein the lapping plate is polished and conditioned by cooperatively rotating the lapping plate and the carrier and feeding loose abrasive grains to the lapping plate,
the conditioning grindstone segment of anyone of claims 1 to 11 being fitted in the bore in the carrier.

13. The lapping plate-conditioning lapping machine of claim 12 wherein the carrier is provided with 2 to 20 circumferentially spaced apart bores each for receiving a conditioning grindstone segment so that the conditioning grindstone segments fitted in the bores figure a petal shape as a whole.

14. A method for conditioning a lapping plate using the conditioning lapping machine of claims 12 or 13, wherein the lapping machine comprises a lapping plate and a conditioning carrier disposed on the lapping plate, the carrier being provided with at least one bore for receiving a conditioning grindstone segment, and wherein the lapping plate is polished and conditioned by cooperatively rotating the lapping plate and the carrier and feeding loose abrasive grains to the lapping plate.

15. A method for conditioning the lapping plate according to claim 14, further comprising feeding loose abrasive grains to the lapping plate during the conditioning operation.
